# EUROPEAN PATENT SPECIFICATION

(11) **EP 1 405 340 B1**
(45) Date of publication and mention of the grant of the patent: **26.12.2012**
(21) Application number: 02738558.2
(22) Date of filing: 03.07.2002
(51) Int. Cl.: H01L 21/28, H01L 29/423

(54) **Manufacturing method of a non-volatile memory transistor with a select gate adjacent to the control gate/floating-gate stack**
Herstellungsverfahren für einen Festwertspeichertransistor mit Auswahlgate neben dem Kontrollgate-/Floating-Gate-Stapel
Procédé de fabrication d'un transistor de mémoire non-volatile ayant une grille de sélection adjacente à l'empilement des grilles de contrôle et flottante

(30) Priority: 03.07.2001 EP 01202552; 18.07.2001 EP 01202729
(43) Date of publication of application: 07.04.2004
(73) Proprietor: NXP B.V., 5656 AG Eindhoven (NL)
(72) Inventor: SCHMITZ, Jurriaan, NL-5656 AA Eindhoven (NL); WIDDERSHOVEN, Franciscus, P., NL-5656 AA Eindhoven (NL); SLOTBOOM, Michiel, NL-5656 AA Eindhoven (NL)
(74) Representative: Schouten, Marcus Maria
(86) International application number: PCT/IB2002/002580
(87) International publication number: WO 2003/005440

(56) References cited:
- EP-A- 0 521 690
- US-A- 5 585 293
- US-A- 6 005 807
- PATENT ABSTRACTS OF JAPAN vol. 2000, no. 20, 10 July 2001 (2001-07-10) & JP 2001 085541 A (HITACHI LTD;HITACHI DEVICE ENG CO LTD), 30 March 2001 (2001-03-30)

## Description

The invention relates to a method of manufacturing a semiconductor device comprising a non-volatile memory with memory cells including a select transistor with a select gate and including a memory transistor with a floating gate and a control gate, in which method active semiconductor regions are formed in a semiconductor body, which active semiconductor regions border on a surface of said semiconductor body and are mutually insulated by field oxide, after which the surface is provided with a layer of gate oxide and a first layer of a conductive material, wherein the select gate is etched, after which the select gate is provided, on its side walls extending transversely to the surface, with an insulating material, and the gate oxide next to the select gate is removed and substituted with a layer of a tunnel oxide, whereafter a second layer of a conductive material, a layer of an intermediate dielectric and a third layer of a conductive material are deposited, in which third layer of conductive material the control gate is formed which extends above and next to the select gate, whereafter the floating gate is etched in the second layer of conductive material, using the control gate as a mask.

Such a method is disclosed in US 5,550,073, wherein, after the formation of the select gate and the insulation on the side walls thereof, a packet of layers comprising the second layer of conductive material, the layer of an intermediate dielectric and the third layer of conductive material are successively deposited. The control gate is etched in the third layer and, using the control gate as a mask, the layer of an intermediate dielectric and the second layer of conductive material are etched in accordance with a pattern, thereby forming the floating gate that is situated right next to the select gate.
When the layer packet comprising the second layer of conductive material, the layer of an intermediate dielectric and the third layer of conductive material are deposited, said layers follow the contours of the select gate formed. Above the select gate, and at a comparatively large distance from said select gate, the layers extend substantially parallel to the surface of the semiconductor body, whereas, next to the select gate, the layers extend substantially perpendicularly to the surface of the semiconductor body. After the layer packet has been deposited, its surface exhibits comparatively large differences in height; the surface exhibits a comparatively pronounced topography. In addition, at the location where the layers in the layer packet extend transversely to the surface of the semiconductor body, said layers exhibit, viewed in the direction transverse to the surface, a large thickness. Due to said pronounced topography and the differences in thickness, it is difficult to form a control gate and a floating gate of small dimensions in the layer packet. These gates are preferably formed such that they have a side wall that extends transversely to the surface of the semiconductor body and is situated next to the region where the layers in the layer packet are comparatively thick. As a result, this side wall is situated at a comparatively large distance from the select gate.

It is an object of the invention to obviate said drawbacks. The invention is defmed by the independent claim. The dependent claims define advantageous embodiments. To achieve this, the method comprises steps as defined in claim 1.
It is to be noted that DE 196 43 185 C2 discloses a method of manufacturing a memory cell comprising a select transistor with a select gate and a memory transistor with a floating gate and a control gate, in which method the select gate and the floating gate are formed so as to be juxtaposed in a first layer of a conductive material. In said method, the select gate and the floating gate are mutually insulated by a groove that is etched in the first layer of conductive material. This flat structure is provided with a layer of an intermediate dielectric, which also fills said groove, and a second layer of a conductive material. A control gate that overlaps the groove is etched in the second layer of conductive material. Subsequently, the select gate and the floating gate are etched in the first layer of conductive material, using said control gate as a mask.
In this method, prior to the deposition of the first layer of conductive material, a gate oxide layer and a tunnel oxide layer are formed on the surface so as to be juxtaposed, and the groove in the first layer of conductive material is formed near the transition between tunnel oxide and gate oxide. In practice, it is impossible to form this groove exactly at the transition from the tunnel oxide to the gate oxide. Thus, the width of the groove must be such that aligning tolerances can be dealt with during the formation of the mask. In the method in accordance with the invention, the tunnel oxide is not formed until after the select gate has been formed and is directly adjacent to the layer of insulating material formed on the side wall of the select gate. In this case, the tunnel oxide/gate oxide transition is situated exactly in the layer of insulating material on the side wall of the select gate.
In practice, the memory cells of a memory are arranged in rows and columns. In this case, for example, the select gates of the select transistors of a column of memory cells are interconnected. This can be achieved by means of an additional wiring layer consisting of a layer of an insulating material on which conductor tracks are provided which are connected to the select gates in contact windows. A simpler way of achieving this consists in that, in the first layer of conductive material, conductive strips serving as select lines are formed so as to extend transversely to the active regions, which conductive strips are provided on the walls extending transversely to the surface with a layer of an insulating material, and which form, at the location of the active regions, the memory transistors' select gates provided with insulating material on the side walls.
In practice, also, for example, the control gates of the memory transistors of a column of memory cells are interconnected by means of word lines. For this purpose use can be made of an additional wiring layer, however, this can also be achieved in a simpler way. For this purpose, after the planarization of the second layer of conductive material, grooves are etched in this layer, which extend transversely to the conductor tracks serving as select lines, the insulating layers formed on the select lines and the surface next to the select lines being exposed in said grooves. During deposition of the layer of an intermediate dielectric and the third layer of conductive material, these grooves are filled. When the comparatively thin layer of the intermediate dielectric is deposited, it follows the contours of the grooves; the comparatively thick layer of conductive material entirely fills the grooves and, after the deposition process, exhibits a substantially flat surface at the location of the grooves. Subsequently, conductive strips, serving as word lines, are formed in the third layer of conductive material and extend parallel to the select lines and at least partly overlap the select lines, which conductive strips form the control gates of the memory transistors at the location of the floating gates. During etching the floating gates, the control gates, i.e. in this case the conductor tracks serving as word lines, are used as a mask. The length of the floating gates, in the direction of the select gates and the control gates, is now determined by the distance between the slits etched in the second layer of conductive material.
Preferably, before forming the select lines in the first layer of conductive material, a layer of an insulating material is deposited on this layer, and the select lines are formed in the first layer of conductive material and in the layer of insulating material deposited thereon. The select lines and hence the select gates are thus readily provided, on the upper side, with an insulating layer.
Preferably, an insulating layer is deposited that is made of a material that can be used as a stop layer when the second layer of conductive material is being planarized. In practice, for the material of the first, second and third layer of conductive material use is made of a layer of silicon, an alloy of silicon and germanium or an alloy of silicon and carbon, which layer is deposited in the form of a polycrystalline or amorphous layer. In this case, preferably a layer of silicon nitride is used as the stop layer.
The planarization of the second layer of conductive material can be terminated in a controlled manner if the planarization operation is continued until the layer of insulating material present on the select gate is exposed. This can be readily detected in practice. If a stop layer is used, the planarization operation even stops at this layer.
A very compact memory cell is obtained if the control gate is formed such that it overlaps the select gate only partly and that, when the second layer of conductive material is subjected to an etching process wherein the control gate is used as a mask, also the exposed part of the select gate is etched away.
If the planarization of the second layer of conductive material is interrupted before this layer of conductive material has been completely removed above the select gate, then the second layer of conductive material will extend over the select gate after the planarization process. As a result, throughout its width, the control gate will be situated on the floating gate. In this manner, a substantial capacitive coupling between control gate and floating gate is obtained. As a result, data can be stored in the memory at a comparatively low voltage on the control gate, and stored data can be read at a comparatively high voltage on the control gate.
If the planarization of the second layer of conductive material is interrupted before this layer has been completely removed above the select gate, a very compact memory cell can be obtained if the second layer of conductive material is locally removed, before the layer of the intermediate dielectric is deposited, so that this second layer of conductive material overlaps the select gate only partly, and the control gate is formed such that it does not completely overlap the select gate, whereas it does completely overlap the second layer of conductive material, and, in the etching process of the second layer of conductive material, wherein the control gate is used as a mask, also the part of the select gate that is not covered by the control gate is etched away. As the second layer of conductive material is locally removed from the select gate, only a layer of an intermediate dielectric is situated at the edge of the control gate between the third layer of conductive material and the select gate. In practice, this enables the select gate to be etched. If the floating gate were situated on the edge of the control gate, then etching of the select gate would seriously affect the edge of the floating gate situated below the intermediate dielectric since, in practice, they are both formed in the same conductive material.

JP2001085541 relates to reliability of a semiconductor integrated circuit with a 3rd gate after repetitive writing, while making the device fine and improving its operating speed. The integrated circuit device has a source-drain diffused layer region of a 2nd conduction type formed in a well of a 1st conductivity- type, a floating gate formed on a semiconductor substrate across an insulating film, a control gate formed on the floating gate across a silicon oxide film into which nitrogen is introduced, and the 3rd gate which is formed across the semiconductor substrate, the floating gate, the control gate, and an insulating film and different from the floating gate and control gate. In this case, the 3rd gate is embedded in the gap of the floating gate perpendicular to word lines and channels, at a altitude lower than the floating gate.
EP0521690 discloses a non-volatile memory comprises an auxiliary gate of polysilicon provided on a Si substrate having a gate insulating and a field oxidation film; a floating gate which is provided on a side wall of the auxiliary gate lying in an active region with a small piece of a first insulating film interposed between them and which is formed by etchback of useless part of a polysilicon side wall spacer; and a control gate of polysilicon provided at least on the floating gate including a second insulating film interposed between them; the floating gate being formed in self-alignment to the control gate.

These and other aspects of the invention will be apparent from and elucidated with reference to the embodiment(s) described hereinafter.
In the drawings:
Fig. 1 is an electrical circuit diagram of a memory formed by means of the method in accordance with the invention,
Figs. 2 through 14 are diagrammatic, cross-sectional plan views of several stages in the manufacture of a first example of a semiconductor device comprising a non-volatile memory, manufactured by means of the method in accordance with the invention,
Fig. 15 and Fig. 16 are diagrammatic, cross-sectional views of stages in the manufacture of a second example of a semiconductor device comprising a non-volatile memory, manufactured by means of the method in accordance with the invention,
Fig. 17 through Fig. 19 are diagrammatic, cross-sectional views of a few stages in the manufacture of a third example of a semiconductor device comprising a non-volatile memory, manufactured by means of the method in accordance with the invention, and
Fig. 20 through Fig. 22 are diagrammatic, cross-sectional views of a few stages in the manufacture of a fourth example of a semiconductor device comprising a non-volatile memory, manufactured by means of the method in accordance with the invention.

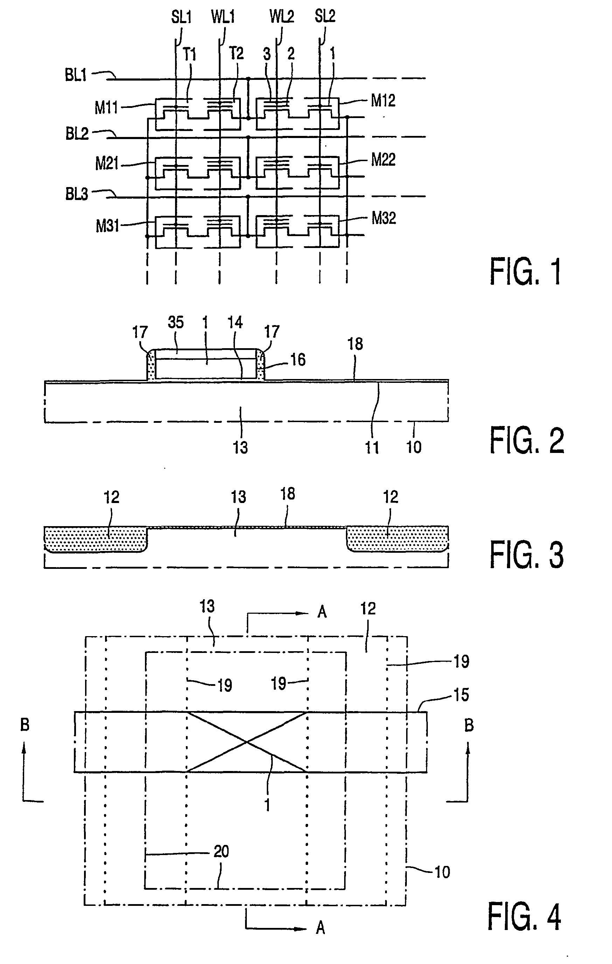

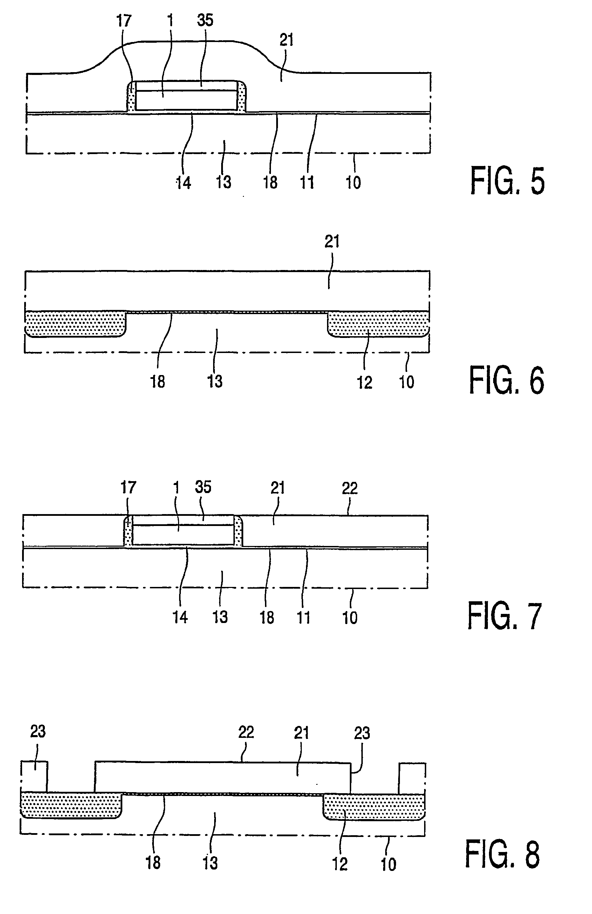

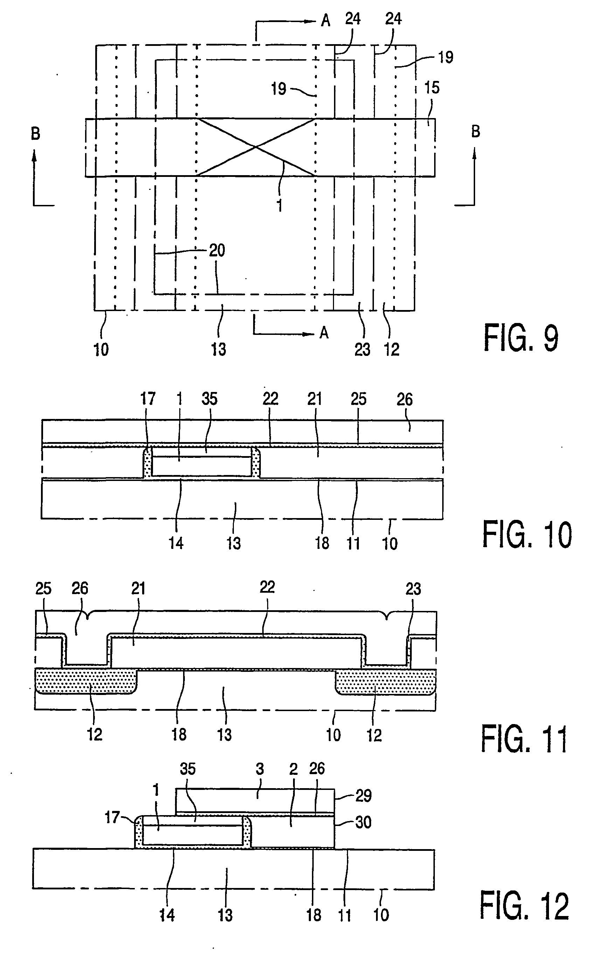

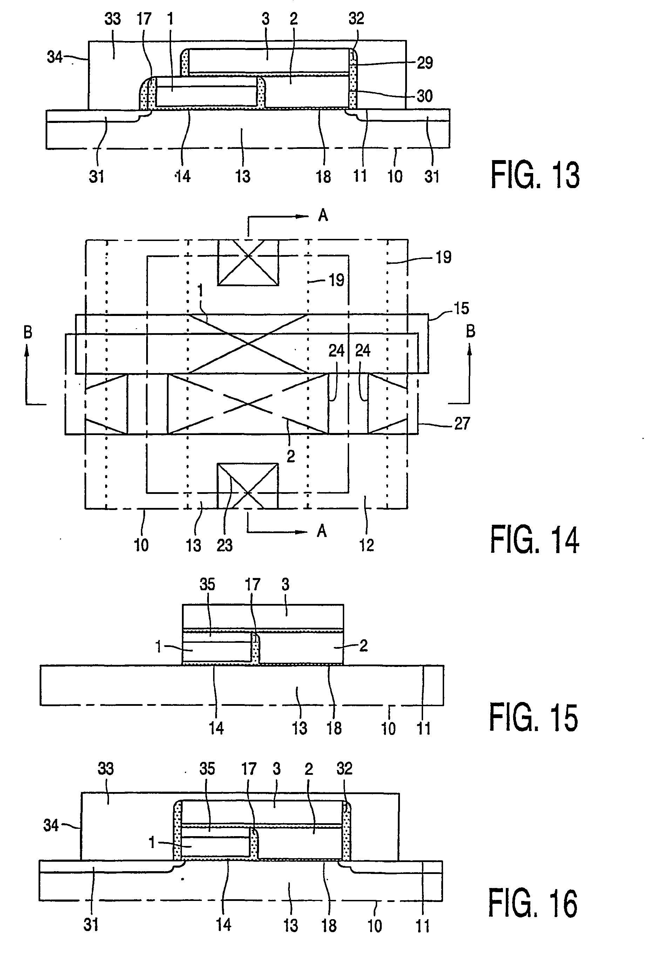

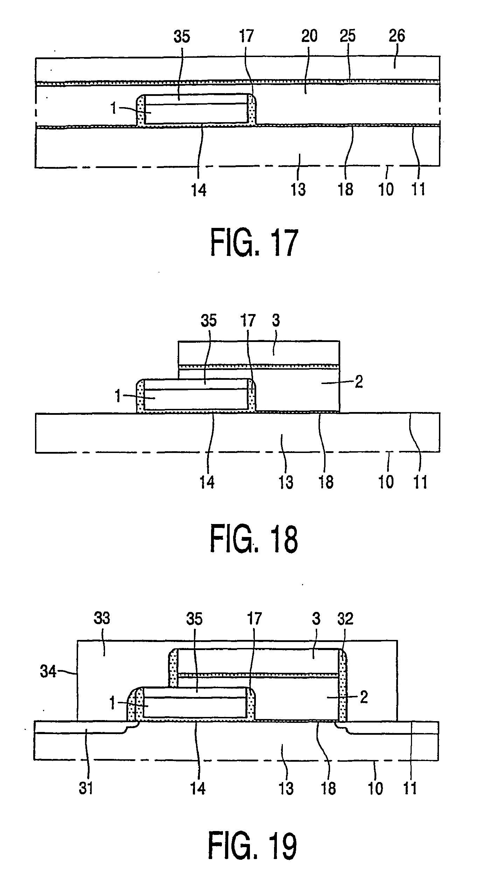

Fig. 1 shows an electrical circuit diagram of a non-volatile memory comprising a matrix of memory cells Mij arranged in rows and columns, where i represents the number in the row and j represents the number in the column. Each memory cell comprises a select transistor T1 with a select gate 1, and a memory transistor T2 which is arranged in series with said select transistor T1 and includes a floating gate 2 and a control gate 3. The select gates 1 of the select transistors T1 are interconnected per column by select lines SLj, the control gates of the memory cells are interconnected per column by word lines WLj. In addition, the memory transistors are connected, per row, with bit lines BLi and the select transistors are connected with a common source line SO.
Figs. 2 through 14 diagrammatically show several stages in the manufacture of a first example of a semiconductor device comprising a non-volatile memory with memory cells including a select transistor T1 with a select gate 1 and including a memory transistor T2 with a floating gate 2 and a control gate 3. In this method, active semiconductor regions 13 which are mutually insulated by field oxide 12 are formed in a semiconductor body 10 so as to border on a surface 11 of said semiconductor body, which, in this case, is a silicon body of which only the top layer is shown which is lightly p-doped with approximately 10¹⁵ atoms per cc. On the surface 11, an approximately 10 nm thick gate oxide layer 14 is formed by thermal oxidation on which, subsequently, an approximately 150 nm thick first layer of a conductive material, in this case n-type doped polycrystalline silicon, is deposited. In this first layer of conductive material, conductive strips 15, which serve as select lines SL, are formed transversely to the active regions 13, which conductive strips are provided with a layer of an insulating material 17 on the walls 16 extending transversely to the surface. At the location of the active regions 13, these strips 15 form the select gates 1 of the memory transistors T2, the side walls of said select gates 1 being provided with an insulating material. The select lines SL and the select gate 1 are formed in the same process steps.
The conductive strip 15 serving as select line SL and hence the select gate 1 is provided with an insulating material 17 on the side walls 16 extending transversely to the surface 11. Said insulating material may be provided by thermal oxidation of the select line 15, or alternatively, as in this case, by providing insulating spacers on the side walls in a customary manner. Subsequently, the gate oxide next to the select gate 1 is removed and substituted with an approximately 7 nm thick tunnel oxide layer 18 formed by thermal oxidation of the surface 11. The structure thus formed is shown in Figs. 2, 3 and 4. Fig. 4 shows this structure in a plan view, wherein the dotted lines 19 are the boundary lines of the field oxide regions 12 and the active regions 13, and wherein the center lines 20 are the boundary lines of one of the memory cells to be formed. Fig. 2 is a cross-sectional view taken on the line A-A in Fig. 4, and Fig. 3 is a cross-sectional view taken on the line B-B.
As shown in Fig. 5 (cross-sectional view taken on the line A-A) and Fig. 6 (cross-sectional view taken on the line B-B) a second layer of a conductive material 21, in this case an approximately 400 nm thick, n-type doped layer of polycrystalline silicon is deposited on the structure shown in Figs. 2 through 4. The second layer of conductive material 21 is deposited in a thickness that exceeds that of the select gate 1, after which this layer of conductive material, as shown in Figs. 7 and 8, is planarized in a customary manner by means of a chemical-mechanical polishing treatment, a flat surface 22 being formed on the second conductive layer 21.
In the planarized second conductive layer 21, approximately 200 nm wide grooves 23 are subsequently etched so as to extend transversely to the select gates 1, in which grooves the insulating layers 17 formed on the select gates and the surface 11 that is present on field isolation regions 12 and extends between the select gates are exposed. This structure is shown in Figs. 8 and 9. The dashed lines 24 are the boundary lines of the grooves 23.
Subsequently, as shown, a layer of an intermediate dielectric 25 (in this case a packet of an approximately 6 nm thick layer of silicon oxide, an approximately 6 nm thick layer of silicon nitride and an approximately 6 nm thick layer of silicon oxide) and an approximately 200 nm thick third layer of a conductive material 26, in this case polycrystalline silicon, are deposited. During the deposition of the layer of an intermediate dielectric 25 and the third layer of a conductive material 26, the grooves 23 are filled. The comparatively thin layer of said intermediate dielectric 25 is deposited so as to follow the contours of the grooves 23, and the comparatively thick conductive layer 16 entirely fills the grooves 23 and, after the deposition process, exhibits a substantially flat surface at the location of the grooves.
In the third layer of conductive material 26, subsequently, conductive strips 27, serving as word lines WL, are etched in a direction parallel to the select lines 15 so as to at least partly overlap these select lines, which conductive strips form the control gates 3 of the memory transistors T2 at the location of the floating gates 2. During etching the floating gates 2, the control gates 3, in this case the conductor tracks 27 serving as word lines WL, are used for masking purposes. The length of the floating gates 2 in the direction of the select gates 1 and the control gates 3, is now determined by the distance between the grooves 23 etched in the second layer of conductive material. In the third layer of conductive material 26, the control gate 3 is formed as described above and extends above and next to the select gate 1, after which the floating gate 2 is etched in the second layer of conductive material 21, using the word line 27, of which the control gate 3 forms part, as a mask.
As shown in Figs. 10, 11 and 12, the layer of intermediate dielectric 25 and the third layer of conductive material 26 are deposited on a flat surface 22 and hence also demonstrate a flat surface 28 and, in addition, a homogeneous thickness. The control gate 3 and the floating gate 2 can be etched without problems in these flat layers. In addition, these gates 3, 2 can be formed so as to comprise a wall 29, 30 which extends transversely to the surface of the semiconductor body and at a comparatively small distance from the select gate 1.
Finally, source and drain regions 31 are formed in a customary manner in the active regions 13, the side walls 29, 30 of the etched control gate 3 and floating gate 2 are provided with insulating spacers 32, a layer of an insulating material 33 is provided wherein windows 34 are etched, through which the source and drain regions 31 can be contacted. The structure thus formed is shown in Figs. 13 and 14.
Prior to the formation of the conductor tracks 15, forming the select lines SL, in the first layer of conductive material, a layer of an insulating material is deposited on this layer and the select lines SL are formed in the first layer of conductive material and in the layer of insulating material deposited thereon. The select lines SL and hence the select gates 1 are thus readily provided, on the top side, with an insulating layer 35, as shown in Fig. 2. Preferably, this insulating layer 35 can be used as a stop layer during the planarization of the second layer of conductive material 20. In this example, use is made of a 100 nm thick layer of silicon nitride.
In the first example shown in Figs. 2 through 14, and in the second example shown in Fig. 15, the planarization process is terminated as soon as the insulating layer 35 has been reached. Planarization of the second layer of conductive material 20 can thus be terminated in a satisfactorily controlled manner.
Figs. 15 and 16 show stages in the manufacture of a second example of a non-volatile memory with a very compact memory cell. These Figures are based on the situation shown in Fig. 10. In this case, the control gate 3 is formed so as to only partly overlap the select gate 1, as shown in Fig. 12. During etching the second layer of conductive material 20, in which process the control gate 1 is used as a mask, also the uncovered part of the select gate 1 is etched away. As a result, the width of the cell is determined by the width of the control gate 1.
After the formation of the floating gate 2, and in this case the select gate 1, source and drain regions 31 are formed in a customary manner, as shown in Fig. 16, in the active regions 13, the side walls 29, 30 of the etched control gate 3 and floating gate 2 are provided with insulating spacers 32, a layer of an insulating material 33 is provided wherein windows 34 are etched through which the source and drain regions 31 can be contacted.
In the manufacture of the third and fourth examples of a non-volatile memory, the planarization of the second layer of conductive material 20, as shown in Fig. 17, is stopped before this layer of conductive material has been entirely removed above the select gate 1. The second layer of conductive material 20 extends, after the planarization process, over the select gate 1. As a result, the control gate 3 will be situated, throughout the width thereof, on the floating gate 2. This results in substantial capacitive coupling between control gate 3 and floating gate 2. By virtue thereof, data can be stored in the memory at a comparatively low voltage on the control gate, and stored data can be read at a comparatively low voltage on the control gate.
Figs. 17 through 19 show several stages in the manufacture of a third example of a semiconductor device with a non-volatile memory. Fig. 18 shows that the floating gate 2 is etched, using the control gate 3 as a mask. In this case, the control gate entirely overlaps the floating gate. In Fig. 19, source and drain regions 31 are formed in the active regions 13, the side walls 29, 30 of the etched control gate 3 and floating gate 2 are provided with insulating spacers 32, a layer of insulating material 33 is provided wherein windows 34 are etched through which the source and drain regions 31 can be contacted.

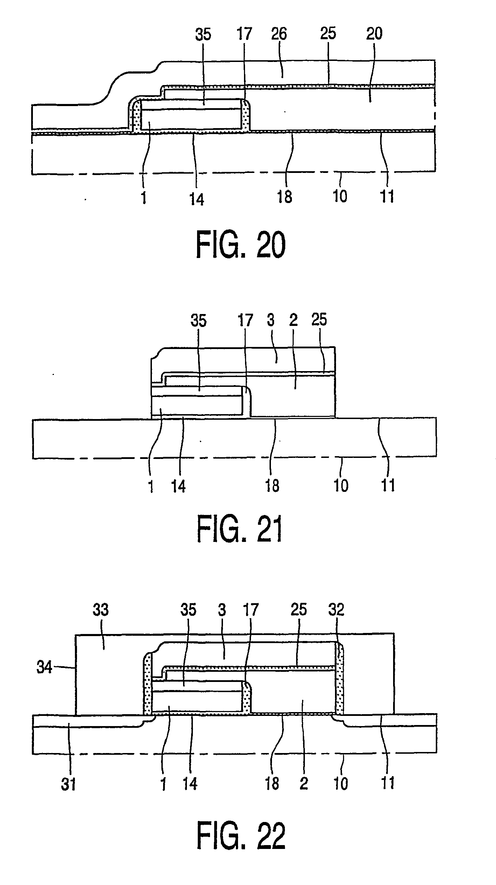

Figs. 20 through 22 show several stages in the manufacture of a fourth example of a semiconductor device with a non-volatile memory. In this case, the second layer of conductive material 20, as shown in Fig. 20, is locally removed before the layer of intermediate dielectric 25 is deposited, as a result of which this second conductive layer 20 only partly overlaps the select gate 1. The control gate 3 is formed such that it does not entirely cover the select gate 1, whereas it does entirely cover the second layer of conductive material 20. During etching the second layer of conductive material 20, in which process the control gate 3 is used as a mask, also the part of the select gate 1 that is not covered by the control gate 3 is etched away. As the second layer of conductive material 20 is locally removed from the select gate 1, only a layer of intermediate dielectric 25 is situated on the edge of the control gate 3 between the third layer of conductive material 26 and the select gate 1. By virtue thereof, etching the select gate 1 becomes possible. If the floating gate 2 were to be present on the edge of the control gate 3, then the edge of the floating gate 2 situated below the intermediate dielectric 25 would be seriously affected during etching the select gate 1.
Fig. 22 shows also in this case that the etched control gate 3 and floating gate 2 are provided with insulating spacers 32, a layer of insulating material 33 is provided wherein windows 34 are etched through which the source and drain regions 31 can be contacted.

## Claims

1. A method of manufacturing a semiconductor device comprising a non-volatile memory with memory cells including a select transistor (T1) with a select gate (1) and including a memory transistor (T2) with a floating gate (2) and a control gate (3),
in which method active semiconductor regions (13) are formed in a semiconductor body (10), which active semiconductor regions border on a surface (11) of said semiconductor body (10) and are mutually insulated by field oxide (12),
after which the surface is provided with a layer of gate oxide (14) and a first layer of a conductive material (16) that is etched to form the select gate (1),
after which the select gate (1) is provided, on its side walls extending transversely to the surface, with an insulating material, and the gate oxide next to the select gate (1) is removed and substituted with a layer of a tunnel oxide (18),
whereafter a second layer of a conductive material (21), a layer of an intermediate dielectric (25) and a third layer of a conductive material (26) are deposited, in which third layer of conductive material (26) the control gate (3) is formed which extends above and next to the select gate (1), wherein the second layer of conductive material (21) is deposited in a thickness that exceeds the thickness of the select gate (1), whereafter this layer (21) of conductive material is planarized before the layer of intermediate dielectric (25) and the third layer (26) of conductive material are deposited,
whereafter the floating gate (2) is etched in the second layer of conductive material (21), using the control gate (3) as a mask,
wherein, in the first layer of conductive material (16), conductive strips (15) serving as select lines (SLj) are formed so as to extend transversely to the active regions, which conductive strips are provided on the walls (16) extending transversely to the surface with a layer of an insulating material (17), and which form, at the location of the active regions, the memory transistors' select gates (1) provided with insulating material on the side walls,
wherein after the planarization of the second layer of conductive material, grooves (23) are etched in this layer, which extend transversely to the conductor tracks serving as select lines (SLj), the insulating layers (17) formed on the select lines and the surface next to the select lines being exposed in said grooves (23) , wherein the layer of an intermediate dielectric and the third layer of conductive material are deposited in these grooves, and wherein conductive strips (27), serving as word lines (WLj), are formed in the third layer of conductive material (26) and extend parallel to the select lines (SLj) and at least partly overlap the select lines, which conductive strips (27) form the control gates (3) of the memory transistors at the location of the floating gates (2).

2. A method as claimed in claim 1, **characterized in that** before forming the select lines (SLj) in the first layer of conductive material (16), a layer of an insulating material (35) is deposited on this layer (16), and the select lines (SLj) are formed in the first layer of conductive material (16) and in the layer of insulating material (35) deposited thereon.

3. A method as claimed in claim 2, **characterized in that** a layer of a material (35) that can be used as a stop layer during the planarization of the second layer of conductive material is deposited on the first layer of conductive material (16).

4. A method as claimed in claim 3, **characterized in that** the first conductive layer (16) is provided, before the planarization operation, with a layer of silicon nitride (35) that serves as a stop layer.

5. A method as claimed in claim 2, 3 or 4, **characterized in that** the planarization of the second layer of conductive material (21) is continued until the layer of insulating material (35) present on the select gate (1) has been exposed.

6. A method as claimed in claim 5, **characterized in that** the control gate (3) is formed such that it overlaps the select gate (1) only partly and that, when the second layer of conductive material (21) is subjected to an etching process wherein the control gate (3) is used as a mask, also the exposed part of the select gate (1) is etched away.

7. A method as claimed in claim 2, 3 or 4, **characterized in that** the planarization of the second layer of conductive material (21) is interrupted before this layer has been completely removed above the select gate (1).

8. A method as claimed in claim 7, **characterized in that** the second layer of conductive material (21) is locally removed before the layer of the intermediate dielectric (25) is deposited, so that this second layer of conductive material (21) only partly overlaps the select gate (1), and **in that** the control gate (3) is formed such that it does not completely cover the select gate (1), whereas it does completely overlap the second layer of conductive material (21), and **in that** during etching the second layer of conductive material (21), in which process the control gate (3) is used as a mask, also the part of the select gate (1) that is not covered by the control gate (1) is etched away.

## Patentansprüche

1. Verfahren zum Herstellen einer Halbleitervorrichtung aufweisend
einen nichtflüchtigen Speicher mit Speicherzellen, welche einen Auswahl-Transistor (T1) mit einem Auswahl-Gate (1) enthalten und einen Speicher-Transistor (T2) mit einem Floating-Gate (2) und einem Steuer-Gate (3) enthalten,
in welchem Verfahren aktive Halbleiterbereiche (13) in einem Halbleiter-Körper (10) gebildet werden, welche aktive Halbleiterbereiche an einer Oberfläche (11) des Halbleiter-Körpers (10) angrenzen und durch ein Feldoxid (12) gegenseitig isoliert sind,
nach welchem die Oberfläche mit einer Schicht von Gate-Oxid (14) und einer ersten Schicht von einem leitenden Material (16) versehen wird, welches von dem Auswahl-Gate (1) geätzt wird,
nach welchem das Auswahl-Gate (1), an dessen Seitenwänden, welche sich transversal zu der Oberfläche erstrecken, mit einem isolierenden Material versehen wird, und wobei das Gate-Oxid neben dem Auswahl-Gate (1) entfernet wird und mit einer Schicht eines Tunnel-Oxides (18) ersetzt wird,
woraufhin eine zweite Schicht eines leitenden Materials (21), eine Schicht eines Zwischen-Dielektrikums (25) und eine dritte Schicht eines leitenden Materials (26) aufgetragen werden, in welcher dritten Schicht von leitendem Material (26) das Steuer-Gate (3) gebildet wird, welches sich über und neben dem Auswahl-Gate (1) erstreckt, wobei die zweite Schicht von leitendem Material (21) in einer Dicke aufgetragen wird, welche die Dicke des Auswahl-Gates (1) übersteigt, woraufhin diese Schicht (21) von leitendem Material planarisiert wird bevor die Schicht von Zwischen-Dielektrikum (25) und die dritte Schicht (26) von leitendem Material aufgebacht werden,
woraufhin das Floating-Gate (2) in der zweiten Schicht von leitendem Material (21) geätzt wird unter Verwenden des Steuer-Gates (3) als eine Maske,
wobei in der ersten Schicht von leitendem Material (16) leitende Streifen (15), welche als Auswahl-Leitungen (SLj) dienen, gebildet werden, um sich transversal zu den aktiven Bereichen erstrecken, welche leitende Streifen an den Wänden (16), welche sich transversal zu der Oberfläche mit einer Schicht eines isolierenden Materials (17) erstreckten, bereitgestellt werden, und welche an der Stelle der aktiven Bereiche die Auswahl-Gates (1) der Speicher-Transistoren bilden, welche mit isolierendem Material an den Seitenwänden versehen sind,
wobei nach der Planarisierung der zweiten Schicht von leitendem Material Nuten (23) in diese Schicht geätzt werden, welche sich transversal zu denen als Auswahl-Leitungen (SLj) dienende Leiter-Spuren erstrecken, wobei die isolierenden Schichten (17) an den Auswahl-Leitungen und der Oberfläche neben den Auswahl-Leitungen, welche in den Nuten (23) freigelegt sind, gebildet werden,
wobei die Schicht eines Zwischen-Dielektrikums und die dritte Schicht von leitendem Material in diesen Nuten aufgetragen werden, und
wobei die als Word-Leitungen (WLj) dienenden leitenden Streifen (27) in der dritten Schicht von leitendem Material (26) gebildet werden und sich parallel zu den Auswahl-Leitungen (SLj) erstrecken und sich zumindest teilweise mit den Auswahl-Leitungen überlappen, welche leitenden Streifen (27) die Steuer-Gates (3) der Speicher-Transistoren an der Stelle der Floating-Gates (2) bilden.

2. Verfahren gemäß Anspruch 1, **dadurch gekennzeichnet, dass** vor Bilden der Auswahl-Leitungen (SLj) in der ersten Schicht von leitendem Material (16) eine Schicht eines isolierenden Materials (35) auf dieser Schicht (16) aufgetragen wird und die Auswahl-Leitungen (SLj) in der ersten Schicht von leitendem Material (16) und in der darauf gebildeten Schicht von isolierendem Material (35) gebildet werden.

3. Verfahren gemäß Anspruch 2, **dadurch gekennzeichnet, dass** eine Schicht eines Materials (35), welches als eine Stopp-Schicht verwendet werden kann während der Planarisierung der zweiten Schicht von leitendem Material auf der ersten Schicht von leitendem Material (16) aufgetragen ist.

4. Verfahren gemäß Anspruch 3, **dadurch gekennzeichnet, dass** die erste leitende Schicht (16) vor der Planarisierungs-Ausführung mit einer Schicht aus Silizium Nitrid (35), welche als eine Stopp-Schicht dient, versehen wird.

5. Verfahren gemäß Anspruch 2, 3 oder 4, **dadurch gekennzeichnet, dass** die Planarisierung der zweiten Schicht von leitendem Material (21) fortgesetzt wird bis die Schicht von isolierendem Material (35), welche an dem Auswahl-Gate (1) anwesend ist, freigelegt wurde.

6. Verfahren gemäß Anspruch 5, **dadurch gekennzeichnet, dass** das Steuer-Gate (3) gebildet wird, sodass es das Auswahl-Gate (1) nur teilweise überlappt, und dass, wenn die zweite Schicht von leitendem Material (21) einem Ätz-Prozess unterzogen wird, bei dem das Steuer-Gate (3) als Maske verwendet wird, auch der freigelegte Anteil des Auswahl-Gates (1) weggeätzt wird.

7. Verfahren gemäß Anspruch 2, 3 oder 4, **dadurch gekennzeichnet, dass** die Planarisierung der zweiten Schicht von leitendem Material (21) abgebrochen wird, bevor diese Schicht oberhalb des Auswahl-Gates (1) vollständig entfernt wurde.

8. Verfahren gemäß Anspruch 7, **dadurch gekennzeichnet, dass**
die zweite Schicht von leitendem Material (21) lokal entfernet wird bevor die Schicht des Zwischen-Dielektrikums (25) aufgetragen wird, sodass diese zweite Schicht von leitendem Material (21) nur teilweise mit dem Auswahl-Gate (1) überlappt, und dass
das Steuer-Gate (3) gebildet wird, sodass es das Auswahl-Gate (1) nicht vollständig bedeckt, wobei es vollständig mit der zweiten Schicht von leitendem Material (21) überlappt, und dass
während des Ätzens der zweiten Schicht von leitendem Material (21), in welchem Prozess das Steuer-Gate (3) als Maske verwendet wird, auch der Anteil des Auswahl-Gates (1), welcher nicht durch das Steuer-Gate (1) bedeckt ist, weggeätzt wird.

## Revendications

1. Procédé de fabrication d'un dispositif à semi-conducteurs contenant une mémoire non volatile avec des cellules de mémoire contenant un transistor de sélection (T1) avec une grille de sélection (1) et contenant un transistor de mémoire (T2) avec une grille flottante (2) et une grille de commande (3),
procédé dans lequel des régions de semi-conducteur actives (13) sont formées dans un corps de semi-conducteur (10), lesquelles régions actives de semi-conducteur sont limitées par une surface (11) dudit corps de semi-conducteur (10) et sont isolées les unes des autres par un oxyde de champ (12),
après quoi sont disposées sur la surface une couche d'oxyde de grille (14) et une première couche de matériau conducteur (16) qui est gravée pour former la grille de sélection (1),
après quoi la grille de sélection (1) reçoit, sur ses parois latérales s'étendant transversalement à la surface, un matériau isolant et l'oxyde de grille à côté de la grille de sélection (1) est éliminé et remplacé par une couche d'oxyde tunnel (18),
après quoi sont déposées une deuxième couche de matériau conducteur (21), une couche d'un diélectrique intermédiaire (25) et une troisième couche de matériau conducteur (26), dans laquelle troisième couche de matériau conducteur (26) est formée la grille de commande (3) qui s'étend au-dessus et à côté de la grille de sélection (1), dans lequel la deuxième couche de matériau conducteur (21) est déposée selon une épaisseur qui dépasse l'épaisseur de la grille de sélection (1), après quoi cette couche (21) de matériau conducteur est aplanie avant que ne soient déposées la couche de diélectrique intermédiaire (25) et la troisième couche de matériau conducteur (26),
après quoi la grille flottante (2) est gravée dans la deuxième couche de matériau conducteur (21) en utilisant la grille de commande (3) comme masque,
dans lequel, dans la première couche de matériau conducteur (16), des bandes conductrices (15) servant de lignes de sélection (SLj) sont formées de manière à ce qu'elles s'étendent de manière transversale par rapport aux régions actives, lesquelles bandes conductrices sont disposées sur les parois (16) s'étendant transversalement par rapport à la surface avec une couche de matériau isolant (17) et qui forment à l'emplacement des régions actives, les grilles de sélection de transistors de mémoire (1) comportant un matériau isolant sur les parois latérales,
dans lequel, après l'aplanissement de la deuxième couche de matériau conducteur, des rainures (23) sont gravées dans cette couche qui s'étendent transversalement jusqu'aux pistes conductrices servant de lignes de sélection (SLj), les couches isolantes (17) formées sur les lignes de sélection et la surface à côté des lignes de sélection étant exposées dans lesdites rainures (23), dans lequel la couche d'un diélectrique intermédiaire et la troisième couche de matériau conducteur sont déposées dans ces rainures, et dans lequel des bandes conductrices (27) servant de lignes de mot (WLj) sont formées dans la troisième couche de matériau conducteur (26) et s'étendent parallèlement aux lignes de sélection (SLj) et recouvrent au moins en partie les lignes de sélection, lesquelles bandes conductrices (27) forment les grilles de commande (3) des transistors de mémoire à l'emplacement des grilles flottantes (2).

2. Procédé selon la revendication 1, **caractérisé par le fait qu'**avant la formation des lignes de sélection (SLj) dans la première couche de matériau conducteur (16), une couche de matériau isolant (35) est déposée sur cette couche (16), et les lignes sélection (SLj) sont formées dans la première couche de matériau conducteur (16) et dans la couche de matériau isolant (35) déposée dessus.

3. Procédé selon la revendication 2, **caractérisé par le fait qu'**une couche de matériau (35) qui peut être utilisée comme couche d'arrêt au cours de l'aplanissement de la deuxième couche de matériau conducteur est déposée sur la première couche de matériau conducteur (16).

4. Procédé selon la revendication 3, **caractérisé par le fait que** la première couche conductrice (16) reçoit avant l'opération d'aplanissement une couche de nitrure de silicium (35) qui sert de couche d'arrête.

5. Procédé selon les revendications 2, 3 ou 4, **caractérisé par le fait que** l'aplanissement de la deuxième couche de matériau conducteur (21) est poursuivi jusqu'à ce que la couche de matériau isolant (35) présente sur la grille de sélection (1) ait été exposée.

6. Procédé selon la revendication 5, **caractérisé par le fait que** la grille de commande (3) est formée de telle sorte qu'elle soit seulement partiellement en recouvrement avec la grille de sélection (1) et que, lorsque la deuxième couche de matériau conducteur (21) est soumise à un processus de gravures dans lequel la grille de commande (3) est utilisée comme masque, la partie exposée de la grille de sélection (1) est également éliminée par gravure.

7. Procédé selon les revendications 2, 3 ou 4, **caractérisé par le fait que** l'aplanissement de la deuxième couche de matériau conducteur (21) est interrompu avant que cette couche n'ait été complètement éliminée au-dessus de la grille de sélection (1).

8. Procédé selon la revendication 7, **caractérisé par le fait que** la deuxième couche de matériau conducteur (21) est éliminée localement avant que la couche de diélectrique intermédiaire (25) ne soit déposée, de telle sorte que cette deuxième couche de matériau conducteur (21) ne recouvre que partiellement la grille de sélection (1), et **par le fait que** la grille de commande (3) est formée de manière à ce qu'elle ne recouvre pas complètement la grille de sélection (1), tandis qu'elle est en complet recouvrement de la deuxième couche de matériau conducteur (21), et **par le fait que** lors de la gravure de la deuxième couche de matériau conducteur (21), procédé au cours duquel la grille de commande (3) est utilisée comme masque, la partie de la grille de sélection (1) qui n'est pas recouverte par la grille de commande (3) est également éliminée par gravure.
